# EUROPÄISCHE PATENTSCHRIFT

(11) **EP 0 764 971 B1**
(45) Veröffentlichungstag und Bekanntmachung des Hinweises auf die Patenterteilung: **11.02.2004**
(21) Anmeldenummer: 96105969.8
(22) Anmeldetag: 16.04.1996
(51) Int. Cl.: H01L 21/00

(54) **Einrichtung zum Ver- und Entriegeln einer Tür eines Behälters**
Opening and closing device for a container door
Dispositif d'ouverture et fermeture de la porte d'un conteneur

(30) Priorität: 22.09.1995 DE 19535178
(43) Veröffentlichungstag der Anmeldung: 26.03.1997
(73) Patentinhaber: Entegris, Inc., Chaska, MN 55318 (US)
(72) Erfinder: Scheler, Werner, 07743 Jena (DE); Schubert, Karl, 07745 Jena (DE); Mages, Andreas, 07745 Jena (DE); Anton, Andreas, 07745 Jena (DE)
(74) Vertreter: Geyer, Werner, Dr.-Ing.

(56) Entgegenhaltungen:
- WO-A-86/00870
- DE-A- 4 207 341
- FR-A- 2 692 170

## Beschreibung

Die Erfindung betrifft eine Einrichtung zum Ver- und Entriegeln einer Tür eines Behälters, insbesondere Behälter für den Transport scheibenförmiger Objekte , mit ein- und ausfahrbaren Verriegelungselementen innerhalb der Tür, die ausgefahren in Ausnehmungen des zu verschließenden Behälters eintauchen.
Die Erfindung ist insbesondere in der Halbleiterindustrie anwendbar, aber auch bei der Herstellung von Flachbildschirmen.
Eine derartige technische Lösung ist beispielsweise aus der US 4 995 430 bekannt.

Zur Beschickung von Halbleiterbearbeitungsanlagen werden häufig sogenannte SMIF-Boxen als Magazinbehälter verwendet, in dem Halbleiterscheibenmagazine aufbewahrt und transportiert werden können. Die Box ist auf einen Öffnungsmechanismus in einer Einhausung aufsetzbar, die eine oder mehrere Arbeitsstationen staubgeschützt umschließt. Box und Öffnungsmechanismus besitzen einander angepaßte Verschlußelemente, die übereinanderliegend sich gleichzeitig öffnen lassen, so daß außen auf den Verschlußelementen aufliegende Staubpartikel dazwischenliegend eingeschlossen werden, wenn das Halbleiterscheibenmagazin zusammen mit den beiden Verschlußelementen in die Einhausung hinein abgesenkt wird. Die Box selbst umschließt die entstehende Öffnung in der Einhausung.

Der in der US 4 995 430 offenbarte Verriegelungsmechanismus zum Öffnen und Schließen einer derartigen SMIF-Box arbeitet in nacheinander ablaufenden Stufen, in denen von einem Verriegelungsmechanismus drei verschiedene Positionen eingenommen werden. Die erste Position entspricht einem eingefahrenen und die zweite einem vollständig ausgefahrenen Zustand. In der vollständig ausgefahrenen Position erfolgt das Schließen der SMIF-Box durch Verkanten des als Hebel ausgebildeten Verriegelungselementes, so daß im Bereich der Verriegelung eine durch Reibung entstehende Partikelerzeugung vermindert ist. Nicht vermindert ist die Partikelerzeugung jedoch in den Bereichen der Betätigung, da zum Verkanten des Verriegelungsmechanismus Keile unter das andere Hebelende geschoben werden.

Die Technik der SMIF-Boxen ist besonders geeignet für Halbleiterscheiben mit herkömmlichem kleineren Durchmesser. Aufgrund der Materialeigenschaften der Halbleiterscheiben werden diese SMIF-Boxen zusammen mit den verwendeten Halbleiterscheibenmagazinen mit zunehmendem Durchmesser der Halbleiterscheiben ungeeigneter als Transportbehälter.
Für derartige Halbleiterscheiben sind bereits Transportbehälter bekannt, die gleichzeitig die Magazinfunktion übernehmen. Eine Entnahme und Beschickung der Halbleiterscheiben erfolgt einzeln in einer Ebene parallel zur Oberfläche der Halbleiterscheiben, wobei der Transportbehälter mit einem senkrecht zur Ebene der Entnahme und Beschickung gerichteten Behälterdeckel verschließbar ist. Der Behälterdeckel wird somit im Gegensatz zur SMIF-Box nicht nach unten, sondern seitlich entfernt bzw. eingesetzt.

Die derzeit bekannten Transportbehälter, für die beim Öffnen und Schließen ebenfalls das Erfordernis der Vermeidung einer Partikelerzeugung besteht, haben den Nachteil, daß sich die Behälterdeckel oft nur schwer oder gar nicht öffnen lassen. Bekannte, voneinander getrennt wirkende Ver- und Entriegelungselemente, die sich durch ihre Vakuumbetätigung und die Möglichkeit der Kapselung günstig auf einen Reinstraum auswirken, müssen für einen sicheren Betrieb mit Sensoren versehen werden, die einen Ausfall signalisieren. Eine Behebung eines Ausfalls ist im automatischen Betrieb zudem mit zusätzlichem Aufwand verbunden.

Aufgabe der Erfindung ist es deshalb, mit einfachen Mitteln die Funktionssicherheit bei der Ver- und Entriegelung in dem Maße zu erhöhen, daß ein Öffnen und Schließen des Transportbehälters im Automatikbetrieb gewährleistet ist. Gleichzeitig ist die Partikelgenerierung weiter zu vermindern.

Die Aufgabe wird durch eine Einrichtung zum Ver- und Entriegeln einer Tür eines Behälters, insbesondere Behälter für den Transport scheibenförmiger Objekte gelöst, mit ein- und ausfahrbaren Verriegelungselementen innerhalb der Tür, die ausgefahren in Ausnehmungen des zu verschließenden Behälters eintauchen, indem das Eintauchen der Verriegelungselemente in die Ausnehmungen entlang einer gekrümmten Bahnkurve erfolgt.

Vorteilhafterweise läßt sich eine derartige gekrümmte Bahnkurve durch technische Mittel erzeugen, die ein Unterlegen von Keilen vermeiden.
Zu diesem Zweck ist jedes Verriegelungselement mit der nach außen weisenden Wand der Tür durch Koppeln verbunden, die in Parallelogrammausführung sowohl am Verriegelungselement als auch an der Wand drehbar gelagert sind, so daß ein im eingefahrenen Zustand zwischen dem Verriegelungselement und der Wand durch die Koppeln bestimmter Abstand vorhanden ist, der sich beim Ausfahren bis zur Auflage auf einer Auflagefläche in der Ausnehmung verringert.

Nachdem der Zustand der Auflage des Verriegelungselementes auf der Auflagefläche in der Ausnehmung ohne wesentliche Reibungseffekte erreicht ist, wird das Verriegelungselement schließlich unter Spannung angedrückt fixiert, so daß der Behälter mit der Tür verschlossen ist.

Es ist von Vorteil, wenn von den Verriegelungselementen einander benachbarte Bestandteil einer parallel zur nach außen weisenden Wand der Tür gerichteten Platte sind, wobei alle Platten einen gemeinsamen, in Richtung der Ver- und Entriegelung wirkenden Antrieb für Verschiebeelemente aufweisen, mit denen die Platten in eingefahrenen und ausgefahrenen Endlagen fixiert sind.

Aus Platzgründen kann es auch von Vorteil sein, wenn jedes Verriegelungselement Bestandteil einer parallel zur nach außen weisenden Wand der Tür gerichteten Platte ist, wobei die Platten einen gemeinsamen, in Richtung der Ver- und Entriegelung wirkenden Antrieb für Verschiebeelemente aufweisen, mit denen die Platten in eingefahrenen und ausgefahrenen Endlagen fixiert sind.

In beiden Fällen lassen sich die Verschiebeelemente als Schubstangen ausbilden, die mit einem Ende an einer Platte und mit dem anderen Ende außerachsial gegenüberliegend an einer Scheibe drehbar befestigt sind. Die Fixierung der Platten in der ausgefahrenen Endlage erfolgt durch Drehung der Scheibe über den Totpunkt hinaus.

Die Erfindung soll nachstehend anhand der schematischen Zeichnung näher erläutert werden. Es zeigen:
- Fig. 1: eine Draufsicht auf eine Tür mit einer Einrichtung zur Ver- und Entriegelung in einer ersten Ausführung im eingefahrenen Zustand
- Fig. 2a: eine Schnittdarstellung der Einrichtung im eingefahrenen Zustand
- Fig. 2b: eine Schnittdarstellung der Einrichtung im ausgefahrenen Zustand
- Fig. 3: den Ausfahrvorgang entlang einer gekrümmten Bahnkurve
- Fig. 4: eine Draufsicht auf einen Teilbereich einer Tür mit einer Einrichtung zur Ver- und Entriegelung in einer zweiten Ausführung im ausgefahrenen Zustand

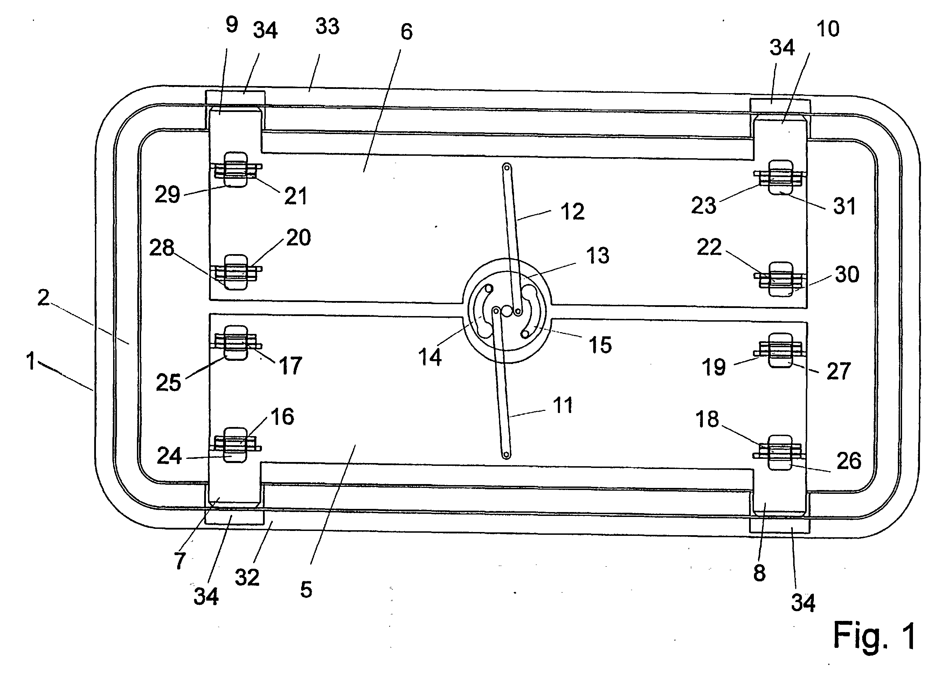

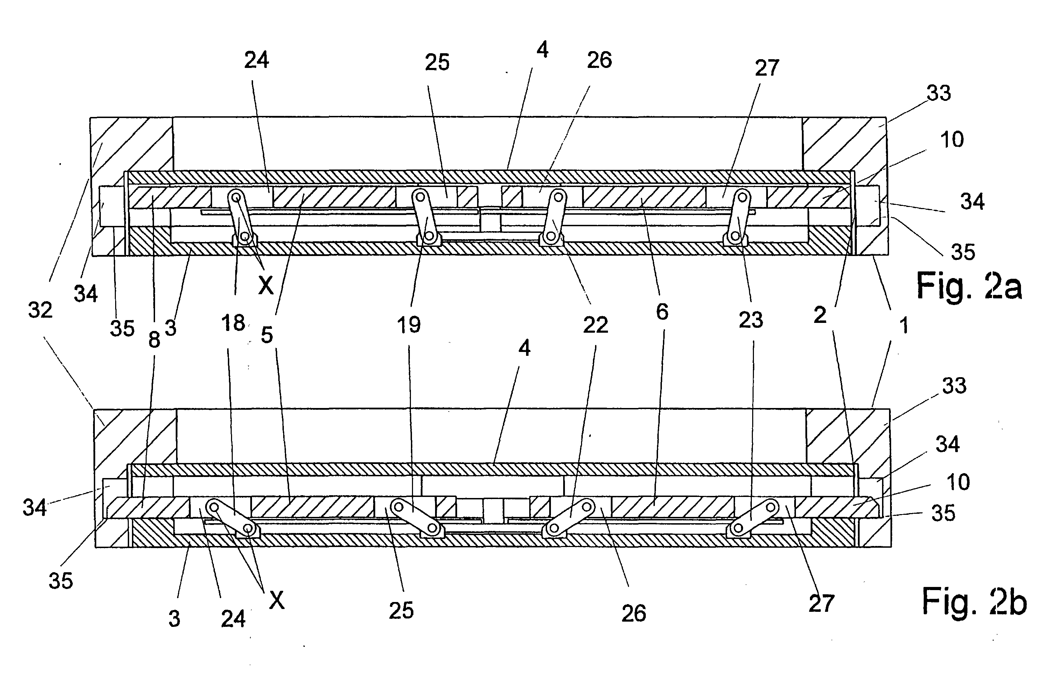

In den Figuren 1, 2a und 2b ist in einem Behälter 1 eine Tür 2 mit einer zwischen Wänden 3, 4 liegenden Einrichtung zur Ver- und Entriegelung eingesetzt. Die Einrichtung besteht im wesentlichen aus zwei Platten 5, 6, die an ihren nach außen weisenden Seiten Verriegelungselemente 7, 8 und 9, 10 in Form von Vorsprüngen besitzen. Die Platten 5 und 6, die parallel zu den Wänden 3, 4 liegen, weisen einen gemeinsamen, in Richtung der Ver- und Entriegelung wirkenden Antrieb für Verschiebeelemente 11, 12 in Form von Schubstangen auf, mit denen die Platten 5, 6 in eingefahrenen und ausgefahrenen Endlagen (siehe Fig. 2a und 2c) nach ihrer Verschiebung fixiert sind. Von dem gemeinsamen Antrieb ist lediglich ein drehbare Scheibe 13 in Fig. 1 dargestellt, an der die Verschiebeelemente 11 und 12 mit jeweils einem Ende außerachsial drehbar befestigt sind. Das andere Ende ist an einer Platte 5 bzw. 6 drehbar befestigt. In die Scheibe 13 sind kreisförmige Nuten 14, 15 eingearbeitet, in die nicht dargestellte, aus einer Drehscheibe ragende Stifte zum Verdrehen der Scheibe 13 eingreifen. Ein zum Antrieb der Drehscheibe dienender Motor liegt außerhalb des Behälters 1 und der Tür 2. Ein ebenfalls nicht dargestellter Signalgeber an der Drehscheibe zur Erkennung der beiden Endlagen gewährleistet die Funktionssicherheit der Einrichtung, da deren übrige Bestandteile miteinander verbunden sind.
Wie die Figuren 2a und 2b in Ergänzung von Fig. 1 zeigen, ist jedes Verriegelungselement 7, 8, 9 und 10 bzw. die Bereiche der Platten 5 und 6, in denen die Verriegelungselemente 7, 8, 9 und 10 vorgesehen sind, mit der nach außen weisenden Wand 3 der Tür 3 durch Koppeln 16, 17, 18, 19, 20, 21, 22 und 23 verbunden ist, die in Parallelogrammausführung sowohl am Verriegelungselement 7, 8, 9 bzw. 10 als auch an der Wand 3 drehbar um Achsen X senkrecht zur Richtung der Ver- und Entriegelung gelagert sind. Von den Achsen X ist der Übersicht halber nur eine bezeichnet. Außerdem sind im Bereich der Befestigungen der Koppeln 16, 17, 18, 19, 20, 21, 22 und 23 der Verriegelungsfunktion dienende Aussparungen 24, 25, 26, 27, 28, 29, 30 und 31 wenigstens in den Platten 5 und 6 vorgesehen.
In die Behälterwände 32 und 33 sind im Bereich der eingesetzten Tür 2 Ausnehmungen 34 eingearbeitet, die einen genügenden Bewegungsraum für die Verriegelungselemente 7, 8, 9 und 10 beim Ver- und Entriegelungsvorgang freilassen. Im verriegelten und damit verschlossenen Zustand des Behälter 1 (Fig. 2b) liegen die Verriegelungselemente 7, 8, 9 und 10 auf Auflageflächen 35 auf.

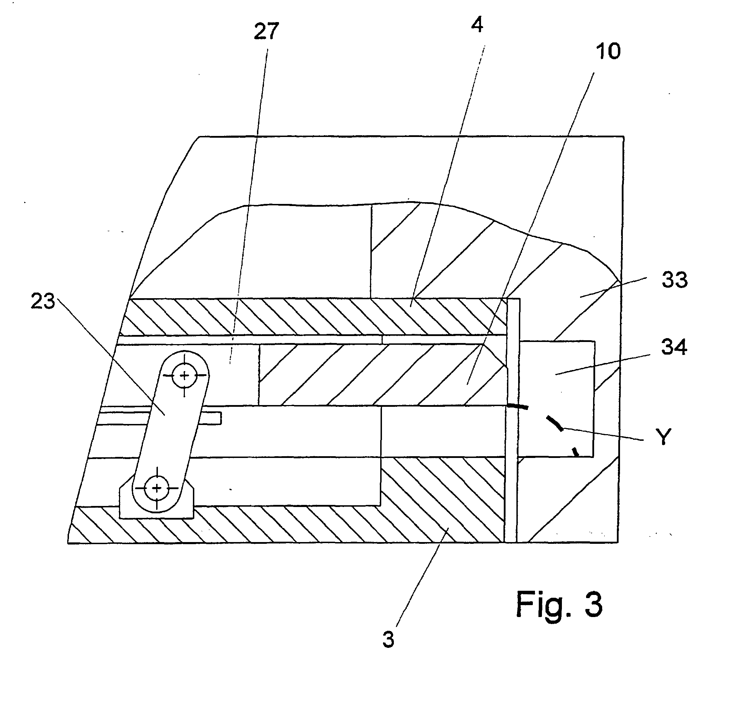

Mit der beschriebenen Einrichtung wird der Behälter 1 in der folgenden Weise verriegelt.
Durch Verdrehen der Scheibe 13, angetrieben durch den Motor über die in die Nuten 14, 15 eingreifenden Stifte, werden die außerachsial befestigten Verschiebeelemente 11 und 12 nach außen bewegt und damit auch die Platten 5 und 6. Diese folgen jedoch keiner geradlinigen, sondern einer gekrümmten Bahnkurve Y, wie Fig. 3 das verdeutlicht. Durch den genügend hohen Bewegungsraum können Verriegelungselemente 7, 8, 9 und 10 unbehindert in die Ausnehmungen 34 eintauchen bis eine Auflage auf den Auflageflächen 35 erfolgt. Durch eine geringfügige Restdrehbewegung der Scheibe 13 über den Totpunkt der Verschiebeelemente 11 und 12 hinaus werden die Verriegelungselemente 7, 8, 9 und 10 unter Spannung gegen die Auflageflächen 35 gedrückt und anschließend fixiert. Auch mit diesem Andrücken unter Spannung ist genau wie bei der Eintauchbewegung bis zur Auflage im wesentlichen keinerlei reibende Wirkung verbunden.
Für eine gut dichtende Verbindung kann selbstverständliche zwischen dem Behälter 1 und der Tür 2 eine Dichtung vorhanden sein. Es ist auch von Vorteil, wenn die Auflageflächen 35 bei eingesetzter Tür 2 die Wand 3 geringfügig überragt.
Das Entriegeln erfolgt in umgekehrter Reihenfolge, wobei auch in der entriegelten Endlage die Verriegelungselemente 7, 8, 9 und 10 fixiert sind.

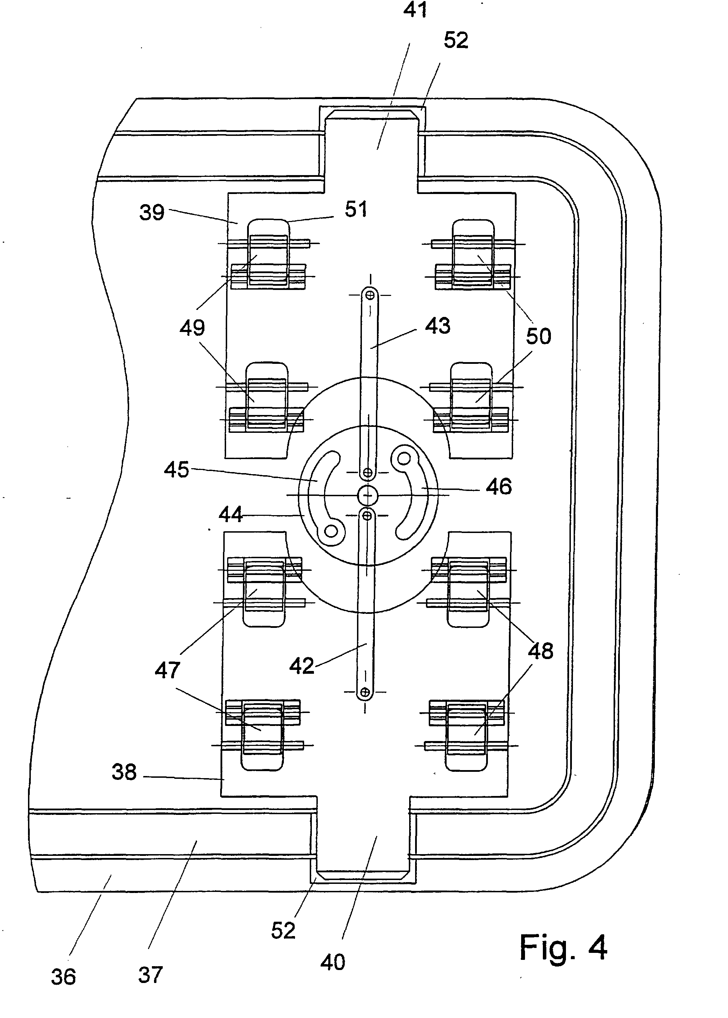

Bei der Ausführung gemäß Fig. 4 wurde auf einen spiegelbildlich gleichgestalteten abgeschnitten Teil der Einrichtung verzichtet.
In einem Behälter 36 ist eine Tür 37 eingesetzt, die ebenfalls zwischen Wänden die Einrichtung zur Ver- und Entriegelung enthält.
Zwei nebeneinander angeordnete Platten 38, 39, die parallel zu den Wänden der Tür 37 liegen, besitzen an ihren nach außen weisenden Seiten Verriegelungselemente 40, 41 in Form von Vorsprüngen. Ein gemeinsamer, in Richtung der Ver- und Entriegelung wirkenden Antrieb für Verschiebeelemente 42, 43 in Form von Schubstangen ist vorgesehen, um die Platten 38, 39 gegeneinander zu verschieben und in den Endlagen zu fixieren.
Von dem gemeinsamen Antrieb ist lediglich ein drehbare Scheibe 44 dargestellt, an der die Verschiebeelemente 42 und 43 mit jeweils einem Ende außerachsial drehbar befestigt sind. Das andere Ende ist an einer Platte 38 bzw. 39 drehbar befestigt. In die Scheibe 44 sind kreisförmige Nuten 45, 46 eingearbeitet, in die nicht dargestellte, aus einer Drehscheibe ragende Stifte zum Verdrehen der Scheibe 44 eingreifen. Ein zum Antrieb der Drehscheibe dienender Motor liegt außerhalb des Behälters 36 und der Tür 37. Ein ebenfalls nicht dargestellter Signalgeber an der Drehscheibe dient zur Erkennung der beiden Endlagen.
Im Unterschied zur ersten Ausführung gemäß Fig. 1 sind aus Stabilitätsgründen für jedes Verriegelungselement 40, 41 bzw. für jede der Platten 38, 39 ein Paar von Koppeln 47, 48, 49, 50 in Parallelogrammausführung zur Verbindung mit der nach außen weisenden Wand der Tür 37 vorgesehen. Ansonsten sind die Koppeln 47, 48, 49, 50 und deren Befestigungen zur ersten Ausführung gleichgestaltet.
Das betrifft auch wenigstens in die Platten 38, 39 eingearbeitete, der Verriegelung dienende Aussparungen, von denen nur eine mit 51 bezeichnet ist.
In die Wände des Behälters 36 sind im Bereich der eingesetzten Tür 37 Ausnehmungen 52 mit entsprechenden Auflageflächen und genügendem Bewegungsraum für die Verriegelungselemente 40, 41 eingearbeitet.

Selbstverständlich ist es möglich, einen anderen als den in dieser Ausführung beschriebenen Antrieb zu wählen, um die Aus- und Einfahrbewegung zu erzeugen, die Kopplung der Verriegelungselemente untereinander anders zu gestalten oder die Anzahl der gekoppelten Verriegelungselemente zu verändern.

## Patentansprüche

1. Behälter mit einer Einrichtung zum Ver- und Entriegeln einer Tür des Behälters, insbesondere Behälter für den Transport scheibenförmiger Objekte, mit ein- und ausfahrbaren Verriegelungselementen innerhalb der Tür, die ausgefahren in Ausnehmungen des zu verschließenden Behälters eintauchen,
**dadurch gekennzeichnet, daß**
das Eintauchen der Verriegelungselemente (7, 8, 9, 10, 40, 41) in die Ausnehmungen (34, 52) entlang einer gekrümmten Bahnkurve (Y) erfolgt.

2. Behälter nach Anspruch 1, **dadurch gekennzeichnet, daß**
zur Erzeugung der gekrümmten Bahnkurve (Y) jedes Verriegelungselement (7, 8, 9, 10, 40, 41 ) mit der nach außen weisenden Wand (3) der Tür (2, 37) durch Koppeln (16, 17, 18, 19, 20, 21, 22, 23, 47, 48, 49, 50) verbunden ist, die in Parallelogrammausführung sowohl am Verriegelungselement (7, 8, 9, 10, 40, 41) als auch an der Wand (3) drehbar gelagert sind, so daß ein im eingefahrenen Zustand zwischen dem Verriegelungselement (7, 8, 9,10,40, 41) und der Wand (3) durch die Koppeln (16, 17, 18, 19, 20, 21, 22, 23, 47, 48, 49, 50) bestimmter Abstand vorhanden ist, der sich beim Ausfahren bis zur Auflage auf einer Auflagefläche (35) in der Ausnehmung (34, 52) verringert.

3. Behälter nach Anspruch 2, **dadurch gekennzeichnet, daß**
von den Verriegelungselementen (7, 8, 9, 10) einander benachbarte Bestandteil einer parallel zur nach außen weisenden Wand (3) der Tür (2) gerichteten Platte (5, 6) sind, wobei alle Platten (5, 6) einen gemeinsamen, in Richtung der Verund Entriegelung wirkenden Antrieb für Verschiebeelemente (11, 12) aufweisen, mit denen die Platten (5, 6) in eingefahrenen und ausgefahrenen Endlagen fixiert sind.

4. Behälter nach Anspruch 2, **dadurch gekennzeichnet, daß**
jedes Verriegelungselementen (40, 41) Bestandteil einer parallel zur nach außen weisenden Wand der Tür (37) gerichteten Platte (38, 39) ist, wobei die Platten (38, 39) einen gemeinsamen, in Richtung der Ver- und Entriegelung wirkenden Antrieb für Verschiebeelemente (42, 43) aufweisen, mit denen die Platten (38, 39) in eingefahrenen und ausgefahrenen Endlagen fixiert sind.

5. Behälter nach Anspruch 3 oder 4, **dadurch gekennzeichnet, daß**
die Verschiebeelemente (11, 12, 42) als Schubstangen ausgebildet sind, die mit einem Ende an einer Platte (5, 6, 38, 39) und mit dem anderen Ende außerachsial gegenüberliegend an einer Scheibe (13, 44) drehbar befestigt sind, und daß die Fixierung der Platten (5, 6, 38, 39) in der ausgefahrenen Endlage durch Drehung der Scheibe (13, 44) über den Totpunkt hinaus erfolgt.

## Claims

1. Container with a device for locking and unlocking a door of the container, in particular for transporting disc-shaped objects, with retractable and extensible locking elements within the door, which elements enter recesses in the container which is to be closed when extended, **characterised in that** the locking elements (7, 8, 9, 10, 40, 41) enter the recesses (34, 52) along a curved path line (Y).

2. Container according to Claim 1, **characterised in that**, in order to produce the curved path line (Y), each locking element (7, 8, 9, 10, 40, 41) is connected to the outward pointing wall (3) of the door (2, 37) by couplers (16, 17, 18, 19, 20, 21, 22, 23, 47, 48, 49, 50), which are pivotably mounted in a parallelogram arrangement both at the locking element (7, 8, 9, 10, 40, 41) and at the wall (3), so that there is a spacing between the locking element (7, 8, 9, 10, 40, 41) and the wall (3) which is determined by the couplers (16, 17, 18, 19, 20, 21, 22, 23, 47, 48, 49, 50) in the retracted state, which spacing decreases upon extension until contact is made with a support surface (35) in the recess (34, 52).

3. Container according to Claim 2, **characterised in that**, of the locking elements (7, 8, 9, 10), adjacent ones thereof are components of a plate (5, 6), which is directed parallel to the outward pointing wall (3) of the door (2), wherein all plates (5, 6) comprise a common drive, which acts in the locking and unlocking direction, for displacement elements (11, 12), with which the plates (5, 6) are fixed in the retracted and extended end positions.

4. Container according to Claim 2, **characterised in that** each locking element (40, 41) is a component of a plate (38, 39), which is directed parallel to the outward pointing wall of the door (37), wherein the plates (38, 39) comprise a common drive, which acts in the locking and unlocking direction, for displacement elements (42, 43), with which the plates (38, 39) are fixed in the retracted and extended end positions.

5. Container according to Claim 3 or 4, **characterised in that** the displacement elements (11, 12, 42) are formed as push rods, which are rotatably fastened by way of one end to a plate (5, 6, 38, 39) and by way of the other end in eccentrically opposite fashion to a disc (13, 14), and that the plates (5, 6, 38, 39) are fixed in the extended end position by rotating the disc (13, 44) beyond the dead centre.

## Revendications

1. Conteneur avec un dispositif pour verrouiller et déverrouiller une porte du conteneur, en particulier conteneur destiné au transport d'objets en forme de disque, avec des éléments de verrouillage susceptibles d'entrer et sortir à l'intérieur de la porte, les éléments sortis s'introduisant dans des évidements du conteneur à verrouiller
**caractérisé en ce que**
l'introduction des éléments de verrouillage (7, 8, 9, 10, 40, 41) dans les évidements (34, 52) s'effectue le long d'une trajectoire courbe (Y).

2. Conteneur selon la revendication 1, **caractérisé en ce que** pour la réalisation de la trajectoire courbe (Y), chaque élément de verrouillage (7, 8, 9, 10, 40, 41) est relié avec la paroi (3), tournée vers l'extérieur, de la porte (2, 37) au moyen de bielles (16, 17, 18, 19, 20, 21, 22, 23, 47, 48, 49, 50) qui, en disposition de parallélogramme, sont montées pivotantes aussi bien sur l'élément de verrouillage (7, 8, 9, 10, 40, 41) que sur la paroi (3), de telle sorte que, grâce aux bielles (16, 17, 18, 19, 20, 21, 22, 23, 47, 48, 49, 50), un écartement déterminé soit présent entre l'élément de verrouillage (7, 8, 9, 10, 40, 41) et la paroi (3), lequel se réduit lors de la sortie jusqu'à l'appui sur une surface d'appui (35) située dans l'évidemment (34, 52).

3. Conteneur selon la revendication 2, **caractérisé en ce que** l'un ou l'autre des composants voisins des éléments de verrouillage (7, 8, 9, 10) est une plaque (5, 6) orientée parallèlement à la paroi (3) tournée vers l'extérieur de la porte (2) grâce à quoi toutes les plaques (5, 6) comportent un mécanisme commun d'entraînement pour les éléments coulissants (11, 12), agissant dans le sens du verrouillage et du déverrouillage, éléments avec lesquels les plaques (5, 6) sont fixées en positions finales d'entrée et de sortie.

4. Conteneur selon la revendication 2, **caractérisé en ce que** chaque composant des éléments de verrouillage (40, 41) est une plaque (38, 39) orientée parallèlement à la paroi tournée vers l'extérieur de la porte (37), les plaques (38, 39) comportant un mécanisme commun d'entraînement pour les éléments coulissants (42, 43), agissant dans le sens du verrouillage et du déverrouillage, éléments avec lesquels les plaques (38, 39) sont fixées en positions finales d'entrée et de sortie.

5. Conteneur selon la revendication 3 ou 4, **caractérisé en ce que** les éléments coulissants (11, 12, 42) sont des bielles de poussée qui sont fixées de manière à pivoter, à une extrémité vers une plaque (5, 6, 38, 39) et à l'autre extrémité vers un disque (13, 44) positionné à l'opposé sur un axe extérieur et **en ce que** la fixation des plaques (5, 6, 38, 39) en position finale de sortie s'effectue grâce à la rotation du disque (13, 44) au-delà du point mort.
